# EUROPEAN PATENT SPECIFICATION

(11) **EP 4 199 352 B1**
(45) Date of publication and mention of the grant of the patent: **14.10.2026**
(21) Application number: 21214440.6
(22) Date of filing: 14.12.2021
(51) Int. Cl.: H03F 3/181, H03F 3/217, H04R 3/00, H03F 1/52, H03M 1/00, H03F 3/45

(54) **VOLTAGE AND CURRENT SENSE CIRCUITS FOR MEASURING A LOAD CONNECTED TO A POWER AMPLIFIER**
SPANNUNGS- UND STROMMESSSCHALTUNGEN ZUR MESSUNG EINER MIT EINEM LEISTUNGSVERSTÄRKER VERBUNDENEN LAST
CIRCUITS DE DÉTECTION DE TENSION ET DE COURANT POUR MESURER UNE CHARGE CONNECTÉE À UN AMPLIFICATEUR DE PUISSANCE

(43) Date of publication of application: 21.06.2023
(73) Proprietor: Goodix Technology (HK) Company Limited, Sheung Shui (HK)
(72) Inventor: Splithof, Mike Hendrikus, 6537 TL Nijmegen (NL); Berkhout, Marco, 6537 TL Nijmegen (NL)
(74) Representative: Lippert Stachow Patentanwälte Rechtsanwälte Partnerschaft mbB

(56) References cited:
- EP-A1- 3 171 515
- US-A- 5 703 490
- US-A1- 2014 142 879
- US-A1- 2021 231 710
- US-A1- 2021 344 310
- "Driving Converters - January 2000", 31 January 2000 (2000-01-31), pages 1 - 62, XP055187294, Retrieved from the Internet <URL:http://people.ece.cornell.edu/wes/Projects/AD_notes/SEMINARS/DRIVING.PDF;1> [retrieved on 20150504]
- RAJPUT DEEPTI: "Designing of an OP-amp using CMFB Technique", 2 January 2017 (2017-01-02), pages 1 - 10, XP055953471, Retrieved from the Internet <URL:http://ijetsr.com/images/short_pdf/1484317765_deepti_ijetsr.pdf> [retrieved on 20220822]
- JOHN HAMBURGER HAMBURGER DOBKIN ET AL: "Analog Circuit Design Volume Three", 2 January 2015 (2015-01-02), Saint Louis, XP055567797, ISBN: 978-0-12-800001-4, Retrieved from the Internet <URL:https://www.analog.com/media/en/technical-documentation/application-notes/an105fa.pdf> [retrieved on 20220822]

## Description

### FIELD OF THE INVENTION

The invention relates to a voltage sense circuit for measuring a load connected to a power amplifier. The invention further relates to a current sense circuit for measuring a load connected to a power amplifier and to a method of operating the voltage and current sense circuits to measure a load connected to a power amplifier.

### BACKGROUND OF THE INVENTION

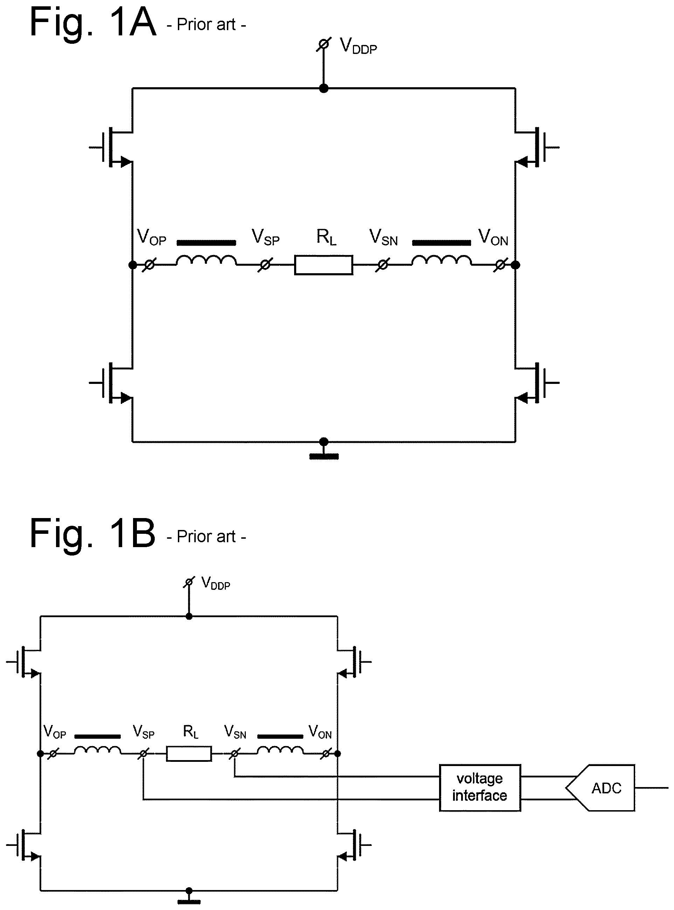

A typical configuration for the output stage of a power amplifier is the bridgetied load (BTL), which is shown in fig. 1A and in which both sides of a load, such as a loudspeaker, are being driven by two outputs in opposite phase. In this way, the current through the load can flow in two opposite directions. Typically, the power amplifier is operated in class-D, which means that the output transistors are switched such that the output voltages are modulated square waves with a typical fundamental frequency around 500 Kilohertz's. Ferrite beads or inductors may be placed between the actual amplifier outputs and the speaker to reduce electromagnetic emission and/or to filter the high-frequency residue due to modulation.

For various reasons, such as for instance for providing speaker protection, it may be desired to measure the impedance of the load connected to the power amplifier. This can be achieved by simultaneously measuring the voltage across the load and the current through the load. For instance, if the load is a speaker, by measuring the load, speaker protection can be provided as the impedance of a speaker provides information about its voice coil temperature, which, in turn, is a measure for the excursion of the speaker membrane as disclosed in "A 4Ω 2.65W Class-D Audio Amplifier with Embedded DC-DC Boost Converter, Current Sensing ADC and DSP for adaptive speaker protection", by Marco Berkhout, Lûtsen Dooper and Benno Krabbenborg, in IEEE Journal of Solid-State Circuits, Vol 48, No 12, pp.2952-2961, 2013.

The measured voltage and current are typically converted to a digital value, which allows further signal processing in the digital domain. Sigma-delta data converters provide a very cost-effective solution for this.

Measuring the voltage across the load can be achieved by observing the difference between the voltages V_{SP} and V_{SN} at both sides of the load as shown in fig. 1B. However, the measurement of said voltage is affected by the large common mode voltage swing that appears on the output nodes of the amplifier.

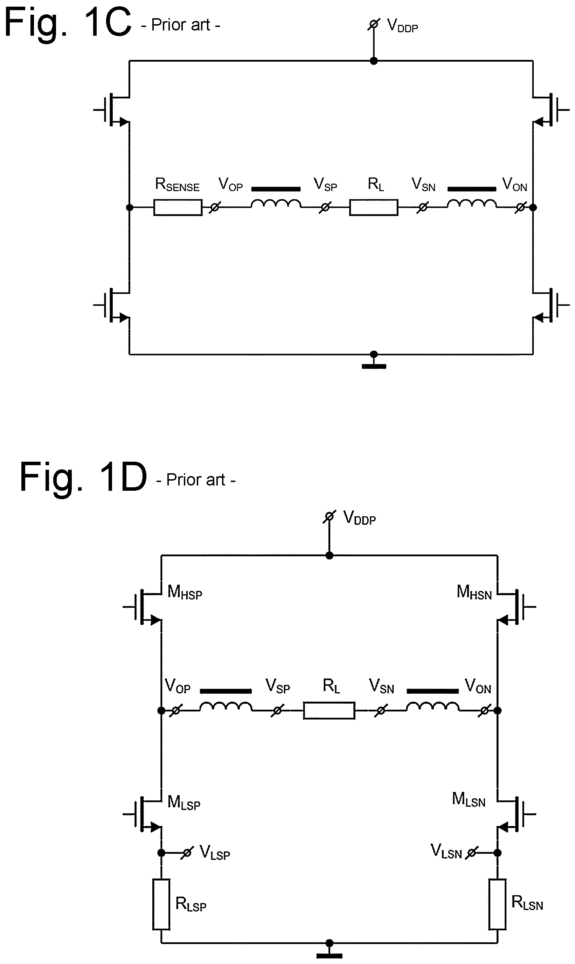

Measuring the current through the load can be accomplished by adding a known measurement resistor R_{SENSE} in series with the load, as shown in fig. 1C, and by measuring the differential voltage across said known measurement resistor. For power efficiency reasons, the impedance of the measurement resistor shall be small compared to the load, typically in the order of 1% of the load or smaller. If the measurement resistor is placed between the outputs of the amplifier and the load, the measurement resistor will experience the same common mode voltage swing as the load, but the differential signal to be observed is much smaller than the voltage across the load. In other words, the common mode rejection requirements for the current interface circuitry will be extremely challenging if this sensing scheme is adopted. This will be at the expense of chip area and/or current consumption.

Alternatively, the measurement resistor(s) can be placed at a different location in the current path. A popular solution is to place two measurement resistors in series with the sources of the low-side output transistors as shown in fig. 1D. Since one leg of each resistor is grounded, the common mode issue is adequately tackled in this way. As far as the AD modulation scheme is concerned, there are two possible circuit states:
1. M_{HSP} and M_{LSN} are simultaneously conducting. The current through R_{L} will flow through RLSN as well (note: the current can still have both polarities due to the presence of an inductor in series with the load)
2. M_{HSN} and M_{LSP} are simultaneously conducting. The current through R_{L} will flow through R_{LSP} as well.

Now, by observing the differential voltage V_{LSP}-V_{LSN}, an adequate measure for the load current can be obtained.

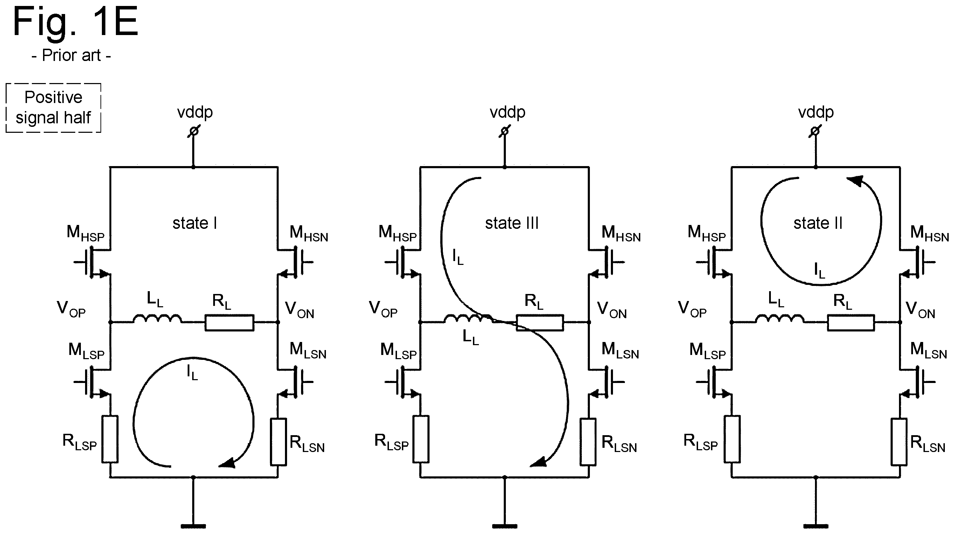

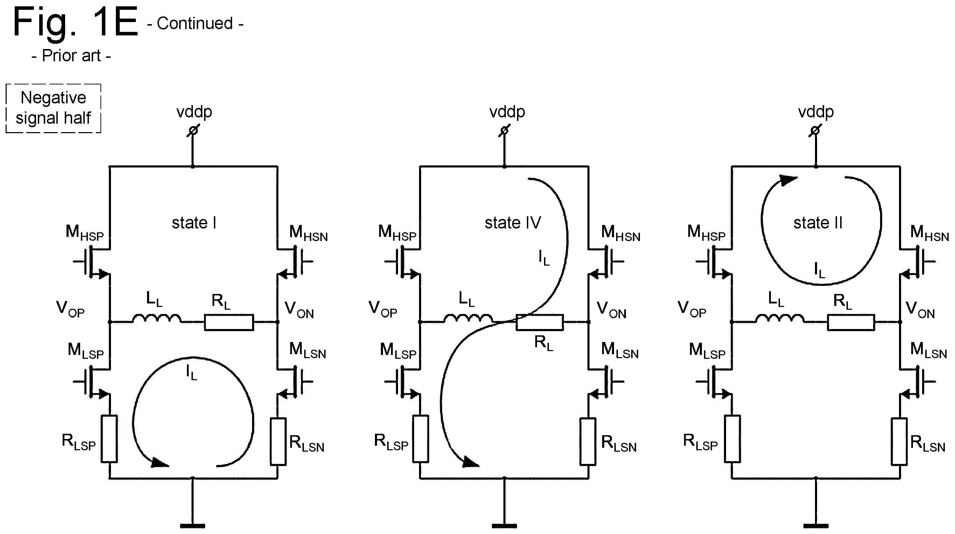

With the BD modulation scheme, however, the measurement is complicated by the fact that there are four possible circuit states. During every PWM period, the output stage will run through three of these states as described below and shown in fig. 1E.
1. For a positive signal half of the audio signal (V_{SP} > V_{SN}), the circuit will successively run through these operation states:
   state I: both V_{OP} and V_{ON} low
   state III: V_{OP} high and V_{ON} low
   state II: both V_{OP} and V_{ON} high
   state III: V_{OP} high and V_{ON} low
   and return to state I. This is shown in the upper part of fig. 1E.
2. For a negative signal half of the audio signal (V_{SP} < V_{SN}), the circuit will operate in these states subsequently:
   state I: both V_{OP} and V_{ON} low
   state IV: V_{OP} low and V_{ON} high
   state II: both V_{OP} and V_{ON} high
   state IV: V_{OP} low and V_{ON} high
   and return to state I. This is shown in the 1 part of fig. 1E

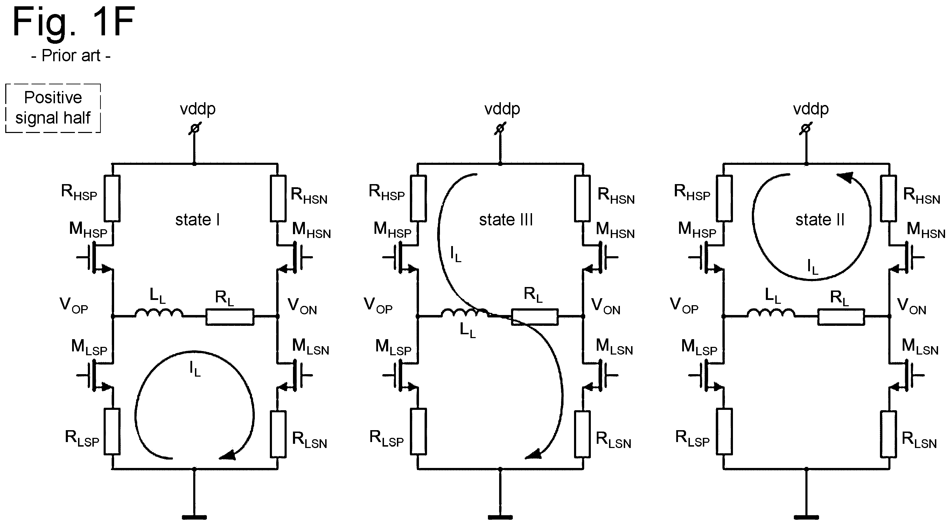

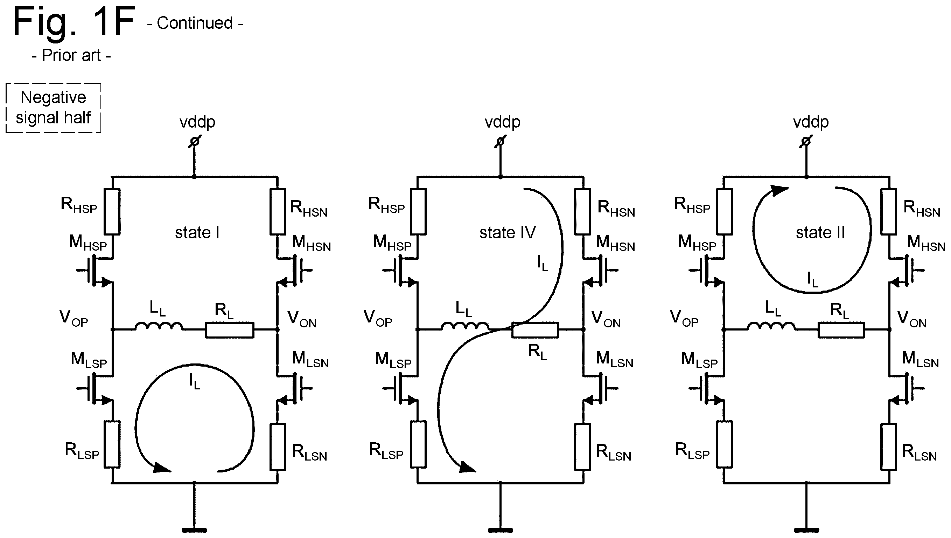

Note that in state I, the load current is sensed by two resistors. In state III and IV, the load current is sensed by one resistor. Finally, in state II, the load current is not sensed at all. This is obviously a source of distortion and requires additional design measures to make the system work. In previous amplifiers, compensation has been used reduce distortion, but has limited performance. Alternatively, including high-side sense resistors in the measurement is a fundamental solution for this problem. Fig. 1F shows how the situation changes when high-side sense resistors are also included in the sensing scheme.

Adding high-side sense resistors solves the distortion issue with BD modulation since the load current is being sensed by two sense resistors, irrespective in which state the output stage operates.

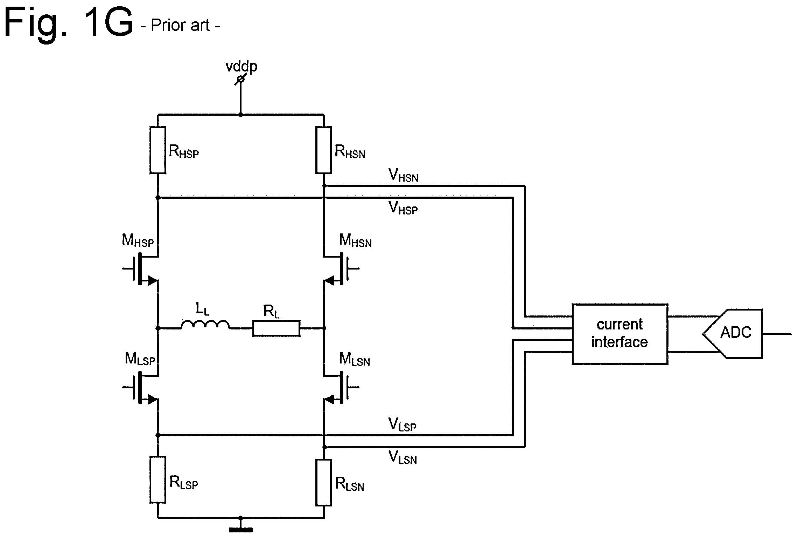

Figure 1G shows a current interface, which is a part of the invention, and whose task it is to combine four sense voltages V_{HSN}, V_{HSP}, V_{LSP} and V_{LSN} into a signal that can be handled by the ADC.

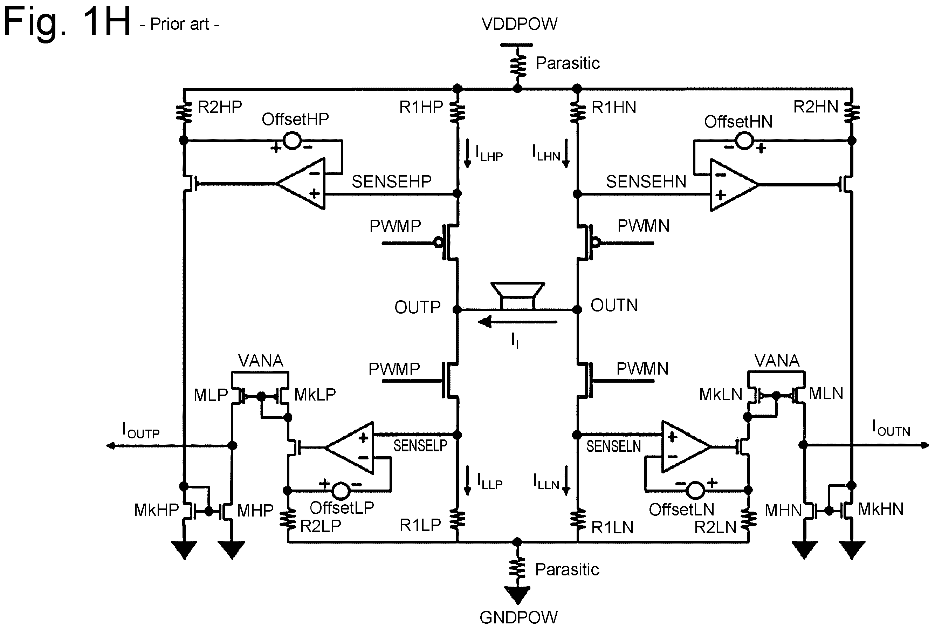

"A fully Integrated Class-D Amplifier in 40nm CMOS with Dynamic Cascode Bias and Load Current Sensing", by Binet et al, ESSCIRC2014- 40th European Solid-State Circuits Conference discloses an implementation of a current interface as shown in fig. 1 H. The operation of this circuit is briefly as follows. The output transistors of the bridge have sense resistors in series with their sources (R_{1HP}, R_{1HN}, R_{1LP}, R_{ILN}). A total of four local amplifiers together with resistors R_{2HP} etc. are configured as VI converters to actively generate scaled copies of the sensed currents. Deliberately added offset sources (called OffsetHP etc...) shall take care that the currents through R2HP etc. will not change polarity, even when the current through R1HP etc. changes direction. Via additional current mirrors, four scaled currents (two per bridge-half) are subsequently summed in the current domain and will leave the circuit at nodes I_{OUTP} and I_{OUTN}.

Since the signals across the sense resistors are small, it is obvious that the four amplifiers must be designed for low-noise, which will be at the expense of power and chip area. Mismatch of the offset sources and current mirrors adds to the mismatch performance of the circuit, which must be compensated for by improving the matching of the resistors R_{2HP} and R_{1HP} etc. Again, this will cost additional chip area. Finally, it must be noted that due to the use of current mirrors, the scaled copies of the sense currents will flow in multiple branches. This will lead to extra power consumption.

Furthermore, regarding the voltage interface, the differential voltage across the load can become as large as the supply voltage of the power stage. This is generally much too large to be handled by an Analog to Digital converter (ADC) that might be attached to Vₒₚ and Vₒₙ. Therefore, the voltage interface must also incorporate attenuation. Also, the supply voltage of the output stage is often modulated with the (audio) signal to further increase efficiency (class-DG operation). This implies that the common mode voltage will vary along with the audio signal. Additionally, due to the class-D operation, the output common mode voltage contains large high-frequency components. Therefore, common mode rejection is an important requirement for the voltage interface. Finally, the output common mode voltage level of the voltage interface shall fit conveniently between the supply rails of the ADC.

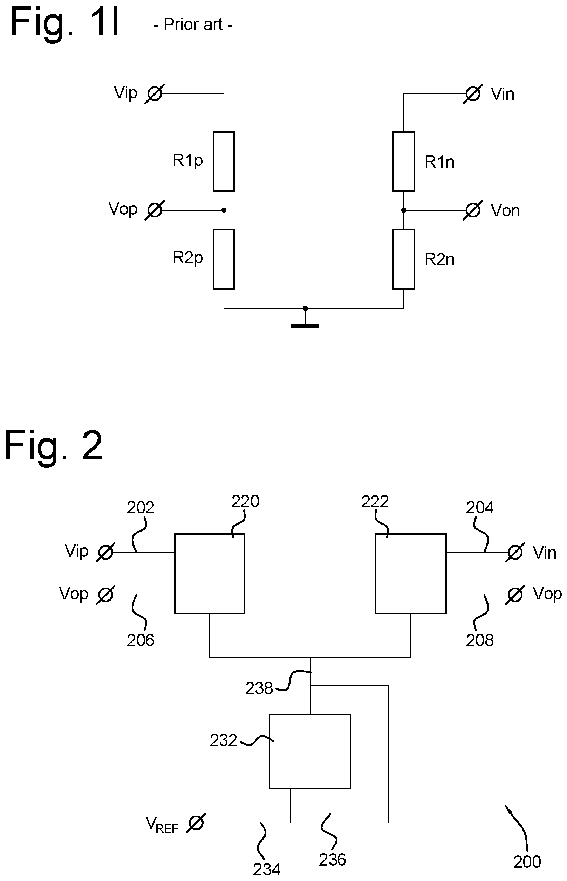

A known technique for rejecting common mode in an amplifier is to use two matched voltage dividers as voltage interface wherein the two matched voltage dividers have zero common mode rejection as shown in fig. 1I. In fig. 1I, voltage level shifting is required to make the signal suitable for the ADC. However, this introduces additional noise and distortion.

Binet et al, "A fully Integrated Class-D Amplifier in 40nm CMOS with Dynamic Cascode Bias and Load Current Sensing", ESSCIRC2014- 40th European Solid-State Circuits Conference discloses a current interface wherein the output transistors of the bridge have sense resistors in series with their sources and a total of four local amplifiers together with the sense resistors are configured as converters to actively generate scaled copies of the sensed currents. Deliberately added offset sources shall take care that the currents through the sense resistors will not change polarity, even when the current through said resistors changes direction. Via additional current mirrors, four scaled currents (two per bridge-half) are subsequently summed in the current domain and will leave the circuit at the output nodes. Since the signals across the sense resistors are small, the four amplifiers must be designed for low-noise, which will be at the expense of power and chip area. Mismatch of the offset sources and current mirrors adds to the mismatch performance of the circuit, which must be compensated for by improving the matching of the sense resistors, which again will cost additional chip area. Finally, that due to the use of current mirrors, the scaled copies of the sense currents will flow in multiple branches, which will lead to extra power consumption.

EP 3171515 A1 describes a speaker driver. ANALOG DEVICES "Driving Converters - January 2000", 31 January 2000, pages 1-62. US 2021/0231710 A1 describes a voltage-to-current architecture and error correction schemes.

It would be advantageous to implement a low cost efficient voltage and current sensing circuits for measuring a load connected to an amplifier that still performs well in terms of noise and distortion.

### SUMMARY OF THE INVENTION

The invention relates to a voltage sense circuit for measuring a load connected to a power amplifier wherein the load is configured to receive a first voltage at a first end and a second voltage at a second end, wherein the first and the second voltages are in opposite phase, wherein the voltage sense circuit comprises a first input terminal coupled to the first voltage, a second input terminal coupled to the second voltage, a first output terminal, a second output terminal, a first voltage divider circuit comprising an input coupled to the first input terminal and an output coupled to the first output terminal, a second voltage divider circuit comprising an input coupled to the second input terminal and an output coupled to the second output terminal and a driver circuit comprising a first input configured to receive a reference voltage, a second input configured to receive a common mode signal of the first and the second voltage divider circuits, and an output configured to drive an output common mode voltage of the first and the second voltage divider circuits with the reference voltage. This allows rejecting the common mode variations such that a differential voltage is converted into a current with an amplitude and a common mode voltage level that can be directly handled by an ADC. For instance, the resulting output current can be directly integrated by the first integrator stage of the sigma-delta converter attached.

The second input of the driver circuit may be connected to the output of the driver circuit. This provides a suitable connection that allows rejecting common mode variations.

Each of the first and second voltage dividers may comprises a pair of resistors wherein each of the pair of resistors comprises a first end and a second end and wherein the first ends of the pair of resistors may be respectively connected to the first and second output terminals and wherein the second ends of the pair of resistors may be connected to each other. This is a very efficient implementation that reduces noise and distortion. In this way, the resulting output current can be directly integrated by the first integrator stage of a sigma-delta converter attached to the voltage sense circuit.

Alternatively, the first and second voltage dividers may be implemented using voltage sources or in any other suitable manner.

The voltage second input and the output of the driver circuit may be connected to the second ends of the pair of resistors. This is a suitable connection to reject common mode variations. However, the voltage second input and the output of the driver circuit may be coupled to the first and second voltage dividers in any suitable way.

The driver circuit may comprise a first and a second resistors connected in series between the first and the second output terminals such that a first end of the first resistor may be coupled to the first output terminal, a second end of the first resistor may be coupled to a first end of the second resistor and a second end of the second resistor may be coupled to the second output terminal, and wherein the second input of the driver circuit may be coupled to the first end of the second resistor. This is a very efficient implementation of the driver circuit that allows common mode rejection at the output of the voltage sense circuit. However, the driver circuit may be implemented in any other suitable way. This is a very efficient implementation using resistors that reduces noise and distortion.

The driver circuit may comprises a first and a second output resistors R₃ₚ-R₃ₙ wherein the first output resistor R₃ₚ may be connected between the first output terminal Iₒₚ and the first end of the first resistor R₂ₚ and the second output resistor R₃ₙ may be connected between the second output terminal Iₒₙ and the second end of the second resistor R₂ₙ. In this way, the physical quantity that the ADC must handle is current and therefore, the same ADC can be connected to the voltage sense interface and to a current sense interface in order to measure both current and voltage to calculate the load. I.e., by adding the first and the second output resistors R₃ₚ-R₃ₙ, which are the first stage of the ADC, the output variable of the voltage sense circuit is current. This would be beneficial since both the current and the voltage sense ADCs can be then identical circuits, both converting current to digital.

The invention further relates to a current sense circuit for measuring a load connected to a power amplifier wherein the load is configured to receive a first voltage Vᵢₚ at a first end and a second voltage Vᵢₙ at a second end, wherein the first and the second voltages are in opposite phase, wherein the current sense circuit comprises a first input terminal coupled to the first voltage V_{HSN}, a second input terminal coupled to the second voltage V_{HSP}, a third input terminal coupled to the third voltage V_{LSN}, a fourth input terminal coupled to the fourth voltage V_{LSP}, a first output terminal Iₒₚ, a second output terminal Iₒₙ, and a common mode loop circuit comprising a first input, a second input, a third input and an output wherein the first and the second inputs are configured to receive a common mode voltage at the first and second output terminals Iₒₚ and Iₒₙ, the third input is configured to receive a reference voltage, and to generate a control signal at the output to switch the current sense circuit such that the common mode voltage equals the reference voltage. In this way, two high-side sense voltages and two low-side sense voltages will be converted to a current at a common mode voltage level suitable for an ADC. For the high-side voltages, which are defined with respect to a supply voltage (and which can contain disturbances), a differential amplifier is being used to reject the common supply variation. It is an important feature that while a differential amplifier is being used for the high-side voltages, the differential amplifier is not needed for the low-side voltages. This is good for noise and distortion. Furthermore, while a common mode loop is used to achieve the suitable output common mode voltage level, this voltage is replicated to the high-side sense resistors thereby re-using the branch currents, which is power and area efficient. The conversion and addition operations are combined such that the resulting output current is directly integrated by the first integrator stage of the sigma-delta converter attached. The invention demonstrates simplest possible implementation in which a minimum amount of circuit elements contribute to output noise, mismatch and distortion.

The current sense circuit may further comprise a differential mode loop circuit comprising a first input and a second input and an output wherein the first and the second inputs are configured to receive a voltage difference and generate a control signal to keep the voltage difference equal to zero.

The current sense circuit may comprise a first transistor M₁ comprising a source, a gate and a drain, a second transistor M₂ comprising a source, a gate and a drain, and a first, second, third and fourth conversion resistors comprising a first end and a second end wherein the first end of the first, second, third and fourth conversion resistors are respectively coupled to the first, second, third and fourth input terminals, and the second end of the first resistor is coupled to the first input of the differential mode loop circuit and to the source of the first transistor M₁, the second end of the second resistor is coupled to the second input of the differential mode loop circuit and to the source of the second transistor M₂, the second end of the third resistor is coupled to the first input of the common mode loop circuit and to the drain of the first transistor M₁, the second end of the fourth resistor is coupled to the second input of the common mode loop circuit and to the drain of the second transistor M₂, and the control signals generated by the common mode loop circuit and the differential mode loop circuit control the gates of the first transistor M₁ and the second transistor M₂. This is a very efficient implementation.

The invention also relates to a method of operating a current sense circuit and/or a method of operating a voltage sense circuit.

The person skilled in the art will understand that the features described above may be combined in any way deemed useful. Moreover, modifications and variations described in respect of the system may likewise be applied to a method.

### BRIEF DESCRIPTION OF THE DRAWINGS

In the following, aspects of the invention will be elucidated by means of examples, with reference to the drawings. The drawings are diagrammatic and are not drawn to scale.
Figs. 1A-1I show known current or voltage sense circuits.
Fig. 2 shows a voltage sense circuit according to an embodiment of the invention.
Fig. 3 shows a voltage sense circuit according to another embodiment of the invention.
Fig. 4 shows a voltage sense circuit according to further embodiment of the invention.
Fig. 5 shows a voltage sense circuit according to another further embodiment of the invention.
Fig. 6 shows a current sense circuit according to an embodiment of the invention.
Fig. 7 shows an implementation of the current sense circuit of fig. 6.
Fig. 8 shows an implementation of a current sense circuit according to an embodiment of the invention.
Fig. 9 shows a power amplifier comprising a current sense circuit and a voltage sense circuit according to the invention.
Fig. 10 shows a flowchart for a method of operating a voltage sense circuit.
Fig. 11 shows a flowchart for a method of operating a current sense circuit.

### DETAILED DESCRIPTION OF EMBODIMENTS

Fig. 2 shows a voltage sense circuit 200 according to a first embodiment of the invention. The voltage sense circuit 200 of fig. 2 comprises a first input terminal 202, a second input terminal 204, a first output terminal 206 and a second output terminal 208. The first input terminal 202 of the voltage sense circuit 200 of fig. 2 is configured to receive a first input voltage Vᵢₚ, the second input terminal 204 is configured to receive a second input voltage Vᵢₙ, the first output terminal 206 is configured to provide a first output voltage Vₒₚ, and the second output terminal 208 is configured to provide a second output voltage Vₒₙ.

The voltage sense circuit 200 of fig. 2 comprises further a first voltage divider circuit 220 and a second voltage divider circuit 222. The first voltage divider circuit 220 comprises an input and an output wherein the input is coupled to the first input terminal 202 of the voltage sense circuit and the output is coupled to the first output terminal 206. The second voltage divider circuit 222 comprises an input and an output wherein the input is coupled to the second input terminal 204 and the output is coupled to the second output terminal 208.

The voltage sense circuit 200 of fig. 2 comprises further a driver circuit 232 wherein the driver circuit 232 comprises a first input 234, a second input 236, and an output 238. The first input 234 of the driver circuit 232 is configured to receive a reference voltage, the second input 234 is coupled to the first voltage divider circuit 220 and to the second voltage divider circuit 222 and is configured to receive a common mode signal, and the output 238 is coupled to the first and the second voltage divider circuits and configured to drive an output common mode voltage of the first and the second voltage divider circuits with the reference voltage.

The voltage sense circuit 200 shown in fig. 2 may be used to measure a load connected to a power amplifier wherein the load is configured to receive the first voltage (Vᵢₚ) at a first end of the load and the second voltage (Vᵢₙ) at a second end of the load, wherein the first and the second voltages are in opposite phase.

In presence of large common mode voltage variations, a differential voltage is converted into a current with an amplitude and a common mode voltage level that can be conveniently handled by an ADC thereby rejecting the common mode variations mentioned. The resulting output current can be directly integrated by the first integrator stage of a sigma-delta converter attached.

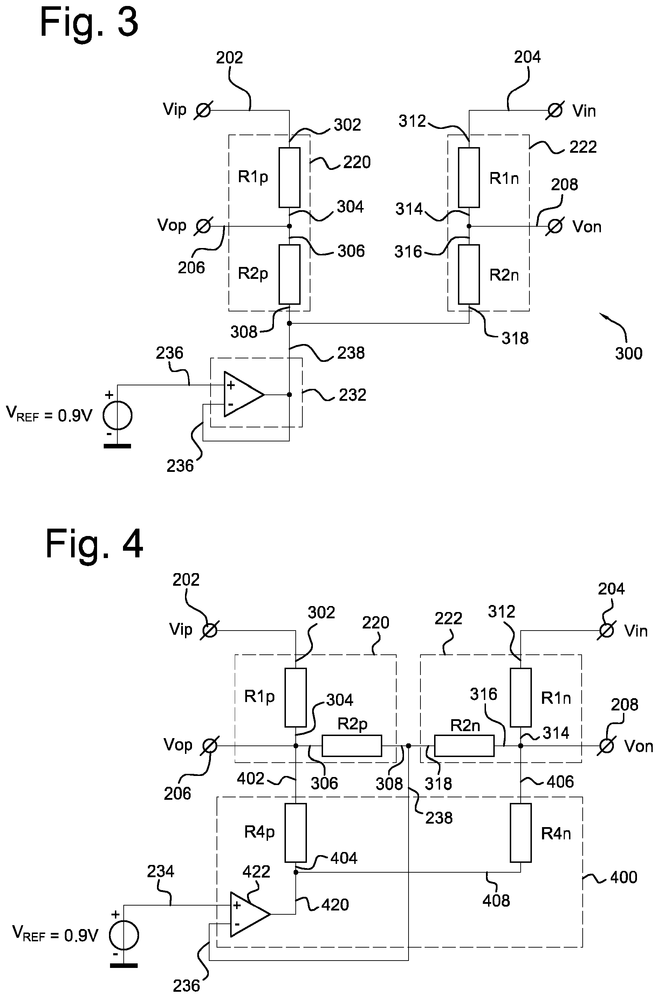

Fig. 3 shows a voltage sense circuit 300 according to a further embodiment of the invention wherein the same reference numbers as in fig. 2 have been used to indicate the same elements. The first voltage divider 220 of fig. 3 comprises a first resistor R₁ₚ and a second resistor R₂ₚ wherein the first resistor R₁ₚ comprises a first end 302 and a second end 304 and the second resistor R₂ₚ comprises a first end 306 and a second end 308. The first end 302 of the first resistor R₁ₚ is connected to the first input terminal 202 of the voltage sense circuit 300, the second end 304 of the first resistor R₁ₚ is connected to the first output terminal 206 of the voltage sense circuit 300, and to the first end 306 of the second resistor R_{2p.} The second end 308 of the second resistor R₂ₚ is connected to the second input 236 and to the output 238 of the driver circuit 232.

The second voltage divider 222 shown in fig. 3 comprises a third resistor R₁ₙ and a fourth resistor R₂ₙ wherein the third resistor R₁ₙ comprises a first end 312 and a second end 314, and the fourth resistor R₂ₙ comprises a first end 316 and a second end 318. The first end 312 of the third resistor R₁ₙ is connected to the second input terminal 204, the second end 314 of the third resistor R₁ₙ is connected to the second output terminal 208 of the voltage sense circuit 300 and to the first end 316 of the fourth resistor R₂ₙ. The second end 318 of the fourth resistor R₂ₙ is connected to the second output 236 of the driver circuit 232, to the output 238 of the driver circuit 232 and to the second end 308 of the second resistor R₂ₚ.

In this way, the output common mode voltage of the voltage sense circuit 300 shown in fig. 3 is not so close to ground, which is not convenient for an ADC that might be attached to the first and second output terminals 206 and 208. Furthermore, common mode rejection at the output of the voltage sense circuit 300 is provided. The common ground node between the second end 308 of the second resistor R₂ₚ and the second end 318 of the fourth resistor R₂ₙ could be replaced by a voltage source, or by a buffer that drives this common ground node with a convenient voltage. In the example shown in fig. 3, the first and second outputs Vₒₚ and Vₒₙ will be around 0.9 Volts, which is convenient if the ADC is supplied by 1.8 Volts with respect to ground. However, this is not limiting and the first and second outputs Vₒₚ and Vₒₙ may have any suitable value.

Fig. 4 shows a further embodiment according to the invention wherein the driver circuit 400 further comprises a first resistor R₄ₚ and a second resistor R₄ₙ compare to the driver circuit 232 shown in fig. 3. The first resistor R₄ₚ comprises a first end 402 and a second end 404. The second resistor R₄ₙ comprises a first end 406 and a second end 408. The first end 402 of the first resistor R₄ₚ of the driver circuit 400 is connected to the first output terminal 206, the second end 408 of the second resistor R₄ₙ is connected to the second output terminal 208, and the second end 404 of the first resistor R₄ₚ is connected to the first end 406 of the second resistor R₄ₙ and to an output 420 of an amplifier 422.

This allows to reject input common mode voltage variations. The loop around the amplifier takes care that the node between the second resistor R₂ₚ and the fourth resistor R₂ₙ will follow the reference voltage that is offered at the non-inverting input of the amplifier. Since there is no low-ohmic path to ground between the second resistor R₂ₚ and the fourth resistor R₂ₙ, the current flowing through the second resistor R₂ₚ must be equal to the current in current flow through the fourth resistor R₂ₙ. Therefore, any positive excursion in Vₒₚ must be accompanied by an equal negative excursion in Vₒₙ. This implies that the output common mode level, (Vₒₚ+Vₒₙ)/2, remains equal to the reference voltage. Any variation in the input common mode voltage will lead to increased common mode currents through the first resistor R₁ₚ and the second resistor R₁ₙ which will be consumed by the output 420 of the amplifier 422 via the first resistor R₄ₚ and the second resistor R₄ₙ of the driver circuit 400. Common mode rejection is achieved in this way.

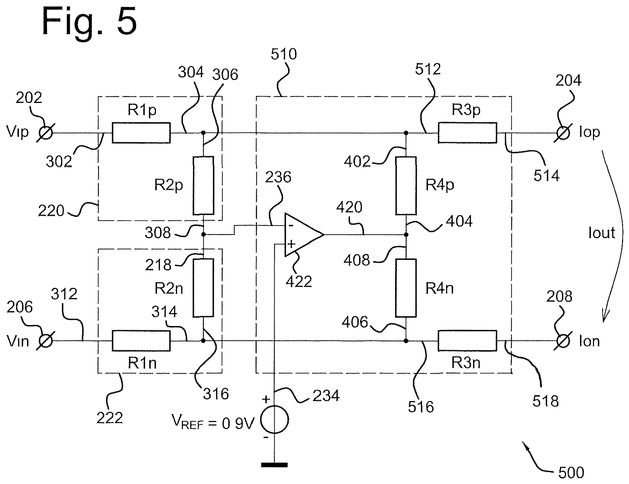

Fig. 5 shows a further embodiment according to the invention wherein the driver circuit 510 comprises a first output resistor R₃ₚ and a second output resistor R₃ₙ compared to the driver circuit 400 of fig. 4. The first output resistor R₃ₚ of the driver circuit 510 comprises a first end 512 and a second end 514 and the second output resistor R₃ₙ of the driver circuit 510 comprises a first end 516 and a second end 518. The second end 514 of the first output resistor R₃ₚ of the driver circuit 510 is connected to the first output terminal 204 and the first end of the first output resistor R₃ₚ of the driver circuit 510 is connected to the first end 402 of the first resistor R₄ₚ. The second end 518 of the second output resistor R₃ₙ of the driver circuit 510 is connected to the second output terminal 208 and the first end 516 of the second output resistor R₃ₙ of the driver circuit 510 is connected to the first end 406 of the second resistor R₄ₙ. The first output terminal 204 and the second output terminal 206 of the voltage sense circuit of fig. 5 are coupled together. In this way, the physical quantity that is handled by an ADC connected to the voltage sense circuit of fig. 5 is a current, as the differential voltages between the first output terminal 204 and the second output terminal 206 deliver a current due to the use of the first output resistor R₃ₚ and a second output resistor R₃ₙ and the coupling of the first and second output terminals.

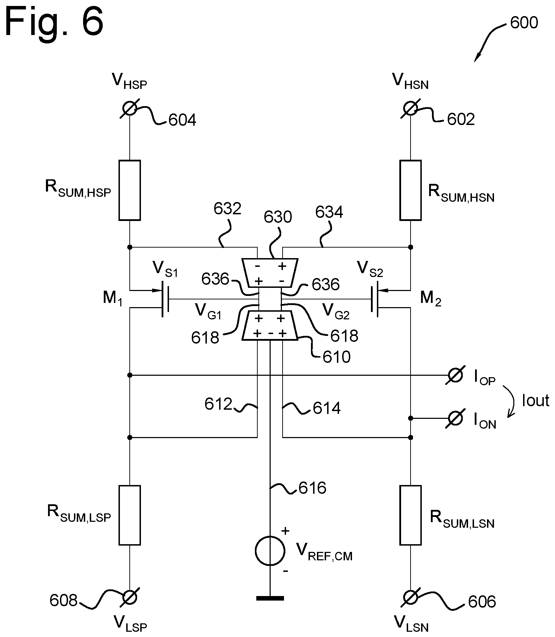

Fig. 6 shows a current sense circuit 600 according to an embodiment of the invention. The current sense circuit 600 comprises a first input terminal 602 coupled to a first voltage V_{HSN}, a second input terminal 604 coupled to the second voltage V_{HSP}, a third input terminal 606 coupled to the third voltage V_{LSN}, a fourth input terminal 608 coupled to a fourth voltage V_{LSP}, a first output terminal Iₒₚ a second output terminal Iₒₙ, and a common mode loop circuit 610. The common mode loop circuit 610 comprises a first input 612, a second input 614, a third input 616 and an output 618. The first and the second inputs of the common mode loop circuit 610 are respectively configured to receive a common mode voltage at the first and second output terminals Iₒₚ and Iₒₙ. The third inout 616 is configured to receive a reference voltage. In this way, the common mode loop circuit 610 is configured to generate a control signal at its output 618 to switch a first transistor M₁ and a second transistor M₂ such that the common mode voltage equals the reference voltage. The current sense circuit 600 further comprises a differential mode loop circuit 630 comprising a first input 632 and a second input 634 and an output 636 wherein the first and the second inputs 632 and 634 are configured to receive a voltage difference such that differential mode loop circuit 630 generates a control signal to control the first transistor M₁ and the second transistor M₂ in order to keep the voltage difference equal to zero. The goal of the current sense interface of fig. 6 is to combine four sense voltages V_{HSN}, V_{HSP}, V_{LSP} and V_{LSN} into one signal that can be processed by the ADC. The high side voltages V_{HSP} and V_{HSN} will vary around a positive supply voltage vddp. The low-side sense voltages V_{LSP} and V_{LSN} will vary around ground level, which is the reference node. The ADC will receive an input current I_{OUT} at a voltage level around half the supply voltage of the ADC. This means that analog voltage level shifting is part of the function. Furthermore, the high-side sense voltages share a common vddp voltage. Some kind of differential amplifier could be used to reject the supply modulations.

The inputs voltages V_{HSP}, V_{HSN}, V_{LSP}, and V_{LSN} connect to the four sense resistors. In absence of load current, V_{HSP} and V_{HSN} will be equal to the voltage of the power stage supply, vddp, and V_{LSP} and V_{LSN} will be equal to ground. The four conversion resistors called R_{SUM,HSP}, R_{SUM,HSN}, R_{SUM,HLP}, and R_{SUM,HLN} are equal. Outputs I_{OP} and I_{ON} are differentially shorted by the first integrator of the sigma-delta loop of the ADC. That implies that any current leaving the I_{OP} node will return via the I_{ON} node. The mathematical function to be fulfilled by the circuit of fig. 6 is: ${I}_{OUT} = \left({V}_{HSP}-{V}_{HSN}-{V}_{LSP}+{V}_{LSN}\right) / {R}_{SUM}$

Addition and subtraction happens on the output nodes and in the current domain thanks to Kirchhoff's first law. As said, the common mode loop circuit 610 will measure the common mode voltage at nodes I_{OP} and I_{ON} and control the gates of M₁ and M₂ in-phase until the common mode voltage equals an external reference voltage, V_{REF,CM}. This means that the currents through R_{SUM,LSP} and R_{SUM,LSN} are both equal to V_{REF,CM}/R_{SUM}. These currents will also flow in R_{SUM,HSP} and R_{SUM,HSN} and, as a consequence, the external reference voltage will also drop across those high-side resistors. An additional high-side reference voltage is no longer needed. Excess voltage (since vddp is relatively large) will drop across cascode transistors M₁ and M₂. Depending on the maximum supply voltage, these may have to be high-voltage type. The differential mode loop circuit 630 will measure the difference between voltage V_{S1} and voltage V_{S2} and adjust that difference to zero by controlling the gate voltages of M₁ and M₂ in opposite phase. An advantage of this circuit is that the entire voltage headroom between the common mode output voltage and ground will drop across the four conversion resistors called R_{SUM,HSP}, R_{SUM,HSN}, R_{SUM,HLP}, and R_{SUM,HLN}. This is the optimum situation for noise within a given current budget. If a cascode transistor would be placed in between the top legs of the conversion resistors and the current outputs, and if the same branch current would have to be maintained, the resistor would have to be smaller to allow the voltage drop across the cascode. A smaller resistor gives more current noise.

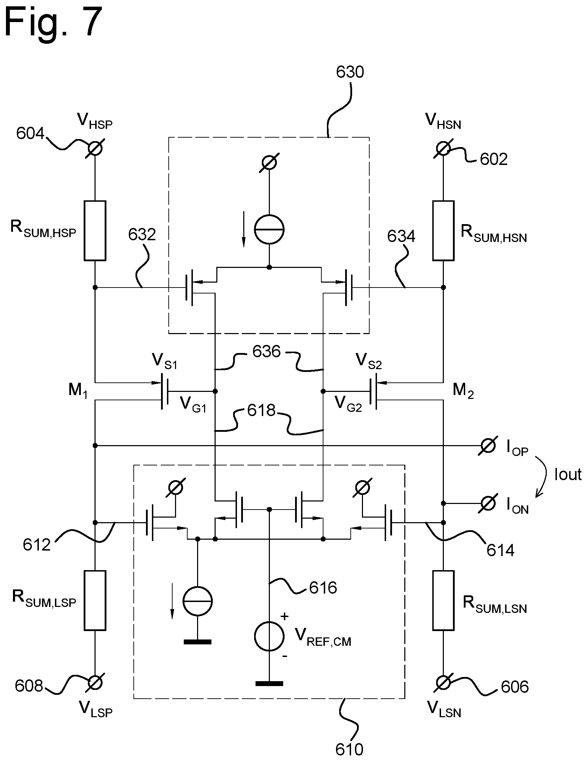

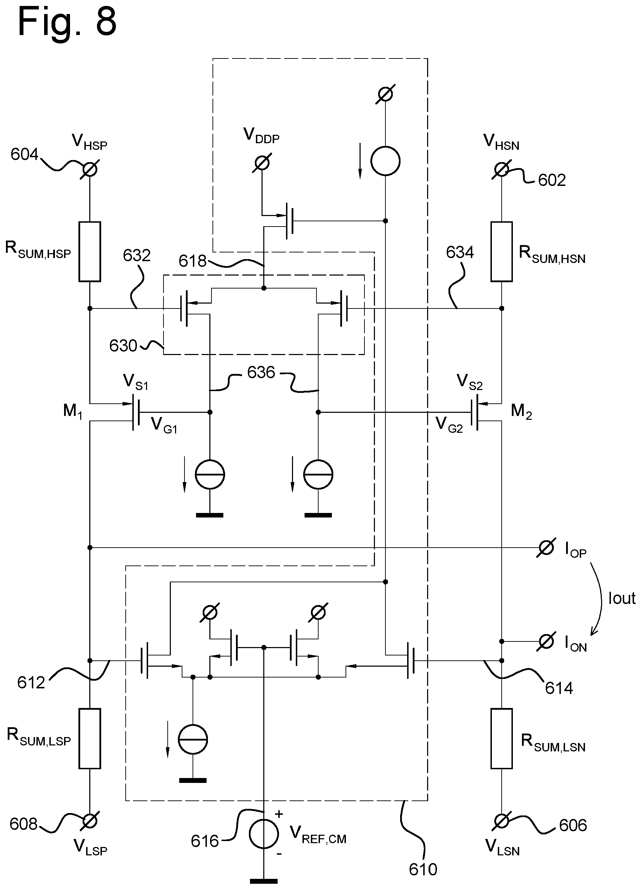

Figs. 7 and 8 show implementations of the current sense circuit of fig. 6 using transistors. The only contributors to differential output current noise are resistors and the differential pair. In fig. 8, instead of controlling the gates of M₁ and M₂ directly, they are controlled in-phase by adjusting the tail current source of the differential mode loop differential pair. The common-mode loop has become a two-stage amplifier in this way, which increases the loop gain for that loop.

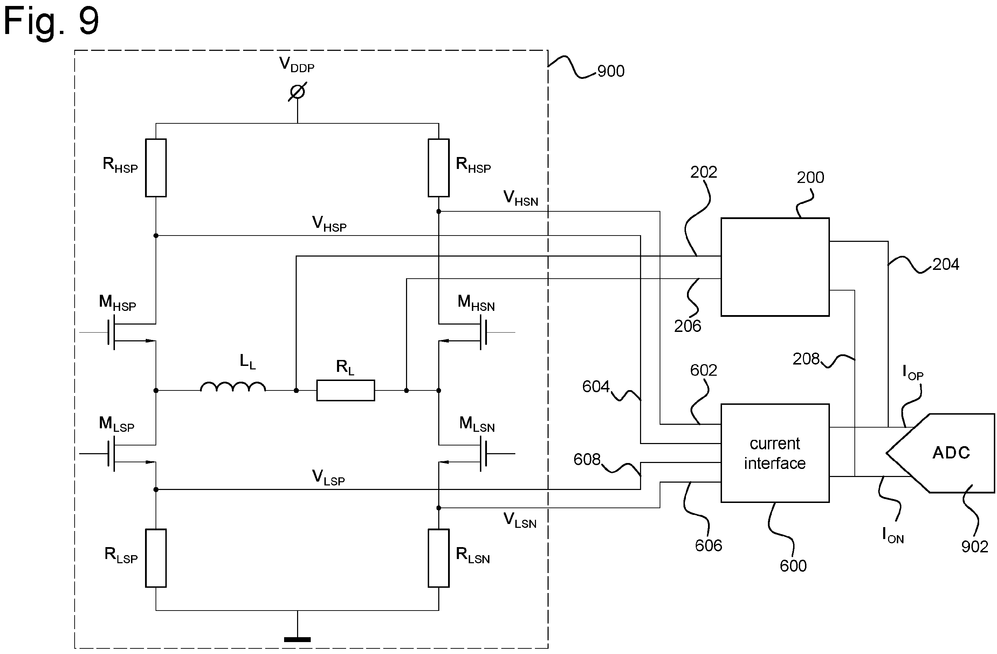

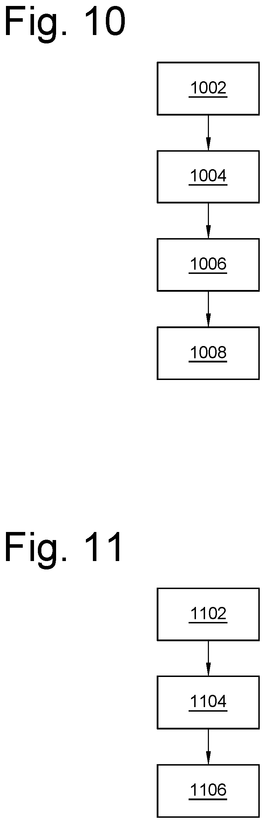

Fig. 9 shows a power amplifier 900 comprising a current sense circuit 600 and a voltage sense circuit 200 according to the invention. Fig. 9 also shows an ADC 902 connected at the output of the current sense circuit 600 and the voltage sense circuit 200.Fig. 10 shows a flowchart for a method of operating a voltage sense circuit for measuring a load connected to a power amplifier wherein the load is configured to receive a first voltage Vᵢₚ at a first end and a second voltage Vᵢₙ at a second end, wherein the first and the second voltages are in opposite phase. The method comprises step 1002 comprising receiving, at an input of a first voltage divider circuit 220 of the voltage sense circuit, the first voltage Vᵢₚ. The method further proceeds to step 1004 by receiving, at an input of a second voltage divider circuit 222 of the voltage sense circuit, the second voltage Vᵢₙ. In step 1006, the method comprises receiving, at a first input 234 of a driver circuit 232 of the voltage sense circuit, a reference voltage, and receiving, at a second input 236 of the driver circuit 232, a common mode signal from the first and the second voltage divider circuits. Finally the method comprises step 1008 comprising driving, by the driver circuit, an output common mode voltage of the first and the second voltage divider circuits with the reference voltage.

Fig. 11 shows a flowchart for a method of operating a current sense circuit for measuring a load connected to a power amplifier wherein the load is configured to receive a first voltage Vᵢₚ at a first end and a second voltage Vᵢₙ at a second end, wherein the first and the second voltages are in opposite phase. The method comprises a step 1102 of receiving, at a first input terminal 602, a first voltage V_{HSN}, receiving at a second input terminal 604, a second voltage V_{HSP}, receiving, at a third input terminal 606, a third voltage V_{LSN} and, receiving, at a fourth input terminal 608, a fourth voltage V_{LSP}. The method further comprises a step 1104 of receiving, at first and second inputs of a common mode loop circuit 610, a common mode voltage at an output of the current sense circuit, and receiving, at a third input of the common mode loop circuit 610, a reference voltage. Finally, the method comprises a step 1106 of generating, at the output of the common mode loop circuit 610, a control signal 636 to switch the current sense circuit 600 such that the common mode voltage equals the reference voltage

The examples and embodiments described herein serve to illustrate rather than limit the invention. The person skilled in the art will be able to design alternative embodiments without departing from the scope of the claims. Reference signs placed in parentheses in the claims shall not be interpreted to limit the scope of the claims. Items described as separate entities in the claims or the description may be implemented as a single hardware or software item combining the features of the items described.

## Claims

1. A voltage sense circuit (400; 500) for measuring a load connected to a power amplifier wherein the load is configured to receive a first voltage (Vᵢₚ) at a first end and a second voltage (Vᵢₙ) at a second end, wherein the first and the second voltages are in opposite phase, wherein the voltage sense circuit comprises:
a first input terminal (202) electrically connected to the first voltage (Vᵢₚ);
a second input terminal (204) electrically connected to the second voltage (Vᵢₙ);
a first output terminal (206);
a second output terminal (208);
a first voltage divider circuit (220) comprising an input electrically connected to the first input terminal (202) and an output electrically connected to the first output terminal (206);
a second voltage divider circuit (222) comprising an input electrically connected to the second input terminal (204) and an output electrically connected to the second output terminal (208); the voltage sense circuit being **characterized in that** it further comprises
a driver circuit (400,510) comprising a first input (234) configured to receive a reference voltage, a second input (236) configured to receive a common mode signal from the first and the second voltage divider circuits, and an output configured to drive an output common mode voltage of the first and the second voltage divider circuits with the reference voltage,
wherein the driver circuit (400,510) further comprises a first and a second resistors (R₄ₚ, R₄ₙ) connected in series between the first and the second output terminals such that a first end (402) of the first resistor (R₄ₚ) is electrically connected to the first output terminal (206), a second end (404) of the first resistor (R₄ₚ) is electrically connected to a first end (408) of the second resistor (R₄ₙ) and to the output (420) of the driver circuit, and a second end (406) of the second resistor (R₄ₙ) is electrically connected to the second output terminal (208).

2. The voltage sense circuit (400;500) according to claim 1,
wherein the first voltage divider (220) comprises a third resistor (R₁ₚ) and a fourth resistor (R₂ₚ) and the second voltage divider (222) comprises a fifth resistor (R₁ₙ) and a fourth resistor (R₂ₙ), and
wherein a first end (302) of the third resistor (R₁ₚ) is electrically connected to the first input terminal (202), a second end (304) of the third resistor (R₁ₚ) is electrically connected to the first output terminal (206) and to a first end (306) of the fourth resistor (R₂ₚ), a second end (308) of the fourth resistor (R₂ₚ) is electrically connected a first end (318) of the fourth resistor (R₂ₙ), a second end (316) of the fourth resistor (R₂ₙ) is electrically connected to the second output terminal (208) and to a first end (314) of the fifth resistor (R₁ₙ), and a second end (312) of the third resistor (R₁ₙ) is electrically connected to the second output terminal (204).

3. The voltage sense circuit (400;500) according to claim 2, wherein the second input (236) of the driver circuit (400,510) is electrically connected to the second end (308) of the fourth resistor (R₂ₚ) and to the first end (318) of the fourth resistor (R₂ₙ).

4. The voltage sense circuit according (500) to claim 1, wherein the driver circuit (510) comprises a first and a second output resistors (R₃ₚ-R₃ₙ) wherein the first output resistor (R₃ₚ) is connected between the first output terminal (204) and the first end (402) of the first resistor (R₄ₚ) and the second output resistor (R₃ₙ) is connected between the second output terminal (Iₒₙ) and the second end of the second resistor (R₂ₙ).

5. The voltage sense circuit according to any of the previous claims, wherein the driver circuit (400, 510) comprises an operational amplifier (422), and wherein a non-inverting input of the operation amplifier (422) is electrically connected to the first input (234), wherein an inverting input of the operational amplifier (422) is electrically connected to the second input (236), and wherein an output (240) of the operational amplifier (422) is electrically connected to the second end (404) of the first resistor (R₄ₚ) and to the first end (408) of the second resistor (R₄ₙ).

6. A power amplifier circuit (900) comprising the voltage sense circuit according to any of the previous claims.

7. The power amplifier circuit of claim 5 further comprising a current sense circuit (600) for measuring a load connected to a power amplifier wherein the load is configured to receive a first voltage (Vᵢₚ) at a first end and a second voltage (Vᵢₙ) at a second end, wherein the first and the second voltages are in opposite phase, wherein the current sense circuit comprises:
a first input terminal (602) coupled to the first voltage (V_{HSN});
a second input terminal (604) coupled to the second voltage (V_{HSP}),
a third input terminal (606) coupled to the third voltage (V_{LSN});
a fourth input terminal (608) coupled to the fourth voltage (V_{LSP});
a first output terminal (Iₒₚ);
a second output terminal (Iₒₙ); and
a common mode loop circuit (610) comprising a first input (612), a second input (614), a third input (616) and an output (618) wherein the first and the second inputs are configured to receive a common mode voltage at the first and second output terminals (Iₒₚ and Iₒₙ), the third input is configured to receive a reference voltage, and to generate a control signal (636) at the output to switch the current sense circuit (600) such that the common mode voltage equals the reference voltage.

8. The power amplifier circuit of claim 6, wherein the current sense further comprises a differential mode loop circuit (630) comprising a first input (632) and a second input (634) and an output (636) wherein the first and the second inputs are configured to receive a voltage difference and generate a control signal (636) to reduce the voltage difference.

9. The power amplifier circuit of claim 7, wherein the current sense circuit further comprises a first transistor (M₁) comprising a source, a gate and a drain, a second transistor (M₂) comprising a source, a gate and a drain, and a first, second, third and fourth conversion resistors comprising a first end and a second end wherein the first end of the first, second, third and fourth conversion resistors are respectively coupled to the first, second, third and fourth input terminals, and the second end of the first resistor is coupled to the first input of the differential mode loop circuit and to the source of the first transistor (M₁), the second end of the second resistor is coupled to the second input of the differential mode loop circuit and to the source of the second transistor (M₂), the second end of the third resistor is coupled to the first input of the common mode loop circuit and to the drain of the first transistor (M₁), the second end of the fourth resistor is coupled to the second input of the common mode loop circuit and to the drain of the second transistor (M₂), and the control signals generated by the common mode loop circuit and the differential mode loop circuit control the gates of the first transistor (M₁) and the second transistor (M₂).

10. The power amplifier circuit of any of claims 6-8, wherein the common mode loop circuit (610) comprises a couple of differential amplifier circuits.

11. The power amplifier circuit of any of claims 6-8, wherein the differential mode loop circuit (630) comprises a differential amplifier circuit.

12. A method of operating a voltage sense circuit (400;510) for measuring a load connected to a power amplifier wherein the load is configured to receive a first voltage (Vᵢₚ) at a first end and a second voltage (Vᵢₙ) at a second end, wherein the first and the second voltages are in opposite phase, the method comprising the steps of:
receiving, at an input of a first voltage divider circuit (220) of the voltage sense circuit, the first voltage (Vᵢₚ);
receiving, at an input of a second voltage divider circuit (222) of the voltage sense circuit, the second voltage (Vᵢₙ);
receiving, at a first input (234) of a driver circuit (400,510) of the voltage sense circuit, a reference voltage,
receiving, at a second input (236) of the driver circuit (400,510), a common mode signal from the first and the second voltage divider circuits; and
driving, by the driver circuit (400,510), an output common mode voltage of the first and the second voltage divider circuits with the reference voltage,
wherein the driver circuit (400,510) further comprises a first and a second resistors (R₄ₚ, R₄ₙ) connected in series between the first and the second output terminals such that a first end (402) of the first resistor (R₄ₚ) is electrically connected to the first output terminal (206), a second end (404) of the first resistor (R₄ₚ) is electrically connected to a first end (408) of the second resistor (R₄ₙ) and to the output (420) of the driver circuit, and a second end (406) of the second resistor (R₄ₙ) is electrically connected to the second output terminal (208).

## Patentansprüche

1. Spannungserfassungsschaltung (400; 500) zum Messen einer Last, die mit einem Leistungsverstärker verbunden ist, wobei die Last konfiguriert ist, um eine erste Spannung (Vᵢₚ) an einem ersten Ende und eine zweite Spannung (Vᵢₙ) an einem zweiten Ende zu empfangen, wobei die erste und die zweite Spannung gegenphasig sind, wobei die Spannungserfassungsschaltung umfasst:
einen ersten Eingangsanschluss (202), der elektrisch mit der ersten Spannung (Vᵢₚ) verbunden ist;
einen zweiten Eingangsanschluss (204), der elektrisch mit der zweiten Spannung (Vᵢₙ) verbunden ist;
einen ersten Ausgangsanschluss (206);
einen zweiten Ausgangsanschluss (208);
eine erste Spannungsteilerschaltung (220), die einen elektrisch mit dem ersten Eingangsanschluss (202) verbundenen Eingang und einen elektrisch mit dem ersten Ausgangsanschluss (206) verbundenen Ausgang umfasst;
eine zweite Spannungsteilerschaltung (222), die einen elektrisch mit dem zweiten Eingangsanschluss (204) verbundenen Eingang und einen elektrisch mit dem zweiten Ausgangsanschluss (208) verbundenen Ausgang umfasst; wobei die Spannungserfassungsschaltung **dadurch gekennzeichnet ist, dass** sie ferner umfasst:
eine Treiberschaltung (400, 510), umfassend einen ersten Eingang (234), der konfiguriert ist, um eine Referenzspannung zu empfangen, einen zweiten Eingang (236), der konfiguriert ist, um ein Gleichtaktsignal von der ersten und der zweiten Spannungsteilerschaltung zu empfangen, und einen Ausgang, der konfiguriert ist, um eine Ausgangsgleichtaktspannung der ersten und der zweiten Spannungsteilerschaltung mit der Referenzspannung anzusteuern,
wobei die Treiberschaltung (400, 510) ferner einen ersten und einen zweiten Widerstand (R₄ₚ, R₄ₙ) umfasst, die in Reihe zwischen dem ersten und dem zweiten Ausgangsanschluss geschaltet sind, sodass ein erstes Ende (402) des ersten Widerstands (R₄ₚ) elektrisch mit dem ersten Ausgangsanschluss (206) verbunden ist, ein zweites Ende (404) des ersten Widerstands (R₄ₚ) elektrisch mit einem ersten Ende (408) des zweiten Widerstands (R₄ₙ) und mit dem Ausgang (420) der Treiberschaltung verbunden ist, und ein zweites Ende (406) des zweiten Widerstands (R₄ₙ) elektrisch mit dem zweiten Ausgangsanschluss (208) verbunden ist.

2. Spannungserfassungsschaltung (400;500) nach Anspruch 1,
wobei der erste Spannungsteiler (220) einen dritten Widerstand (R₁ₚ) und einen vierten Widerstand (R₂ₚ) umfasst, und der zweite Spannungsteiler (222) einen fünften Widerstand (R₁ₙ) und einen vierten Widerstand (R₂ₙ) umfasst, und
wobei ein erstes Ende (302) des dritten Widerstands (R₁ₚ) elektrisch mit dem ersten Eingangsanschluss (202) verbunden ist, ein zweites Ende (304) des dritten Widerstands (R₁ₚ) elektrisch mit dem ersten Ausgangsanschluss (206) und mit einem ersten Ende (306) des vierten Widerstands (R₂ₚ) verbunden ist, ein zweites Ende (308) des vierten Widerstands (R₂ₚ) elektrisch mit einem ersten Ende (318) des vierten Widerstands (R₂ₙ) verbunden ist, ein zweites Ende (316) des vierten Widerstands (R₂ₙ) elektrisch mit dem zweiten Ausgangsanschluss (208) und mit einem ersten Ende (314) des fünften Widerstands (R₁ₙ) verbunden ist, und ein zweites Ende (312) des dritten Widerstands (R₁ₙ) elektrisch mit dem zweiten Ausgangsanschluss (204) verbunden ist.

3. Spannungserfassungsschaltung (400; 500) nach Anspruch 2, wobei der zweite Eingang (236) der Treiberschaltung (400, 510) elektrisch mit dem zweiten Ende (308) des vierten Widerstands (R₂ₚ) und mit dem ersten Ende (318) des vierten Widerstands (R₂ₙ) verbunden ist.

4. Spannungserfassungsschaltung (500) nach Anspruch 1, wobei die Treiberschaltung (510) einen ersten und einen zweiten Ausgangswiderstand (R₃ₚ bis R₃ₙ) umfasst, wobei der erste Ausgangswiderstand (R₃ₚ) zwischen den ersten Ausgangsanschluss (204) und das erste Ende (402) des ersten Widerstands (R₄ₚ) geschaltet ist, und der zweite Ausgangswiderstand (R₃ₙ) zwischen den zweiten Ausgangsanschluss (Iₒₙ) und das zweite Ende des zweiten Widerstands (R₂ₙ) geschaltet ist.

5. Spannungserfassungsschaltung nach einem der vorstehenden Ansprüche, wobei die Treiberschaltung (400, 510) einen Operationsverstärker (422) umfasst, und wobei ein nichtinvertierender Eingang des Operationsverstärkers (422) elektrisch mit dem ersten Eingang (234) verbunden ist, wobei ein invertierender Eingang des Operationsverstärkers (422) elektrisch mit dem zweiten Eingang (236) verbunden ist, und wobei ein Ausgang (240) des Operationsverstärkers (422) elektrisch mit dem zweiten Ende (404) des ersten Widerstands (R₄ₚ) und mit dem ersten Ende (408) des zweiten Widerstands (R₄ₙ) verbunden ist.

6. Leistungsverstärkerschaltung (900), umfassend die Spannungserfassungsschaltung nach einem der vorstehenden Ansprüche.

7. Leistungsverstärkerschaltung nach Anspruch 5, ferner umfassend eine Stromerfassungsschaltung (600) zum Messen einer mit einem Leistungsverstärker verbundenen Last, wobei die Last konfiguriert ist, um eine erste Spannung (Vᵢₚ) an einem ersten Ende und eine zweite Spannung (Vᵢₙ) an einem zweiten Ende zu empfangen, wobei die erste und die zweite Spannung gegenphasig sind, wobei die Stromerfassungsschaltung umfasst:
einen ersten Eingangsanschluss (602), der mit der ersten Spannung (V_{HSN}) gekoppelt ist;
einen zweiten Eingangsanschluss (604), der mit der zweiten Spannung (V_{HSP}) gekoppelt ist;
einen dritten Eingangsanschluss (606), der mit der dritten Spannung (V_{LSN}) gekoppelt ist;
einen vierten Eingangsanschluss (608), der mit der vierten Spannung (V_{LSP}) gekoppelt ist;
einen ersten Ausgangsanschluss (Iₒₚ);
einen zweiten Ausgangsanschluss (Iₒₙ); und
eine Gleichtaktschleifenschaltung (610), die einen ersten Eingang (612), einen zweiten Eingang (614), einen dritten Eingang (616) und einen Ausgang (618) umfasst, wobei der erste und der zweite Eingang konfiguriert sind, um eine Gleichtaktspannung an dem ersten und an dem zweiten Ausgangsanschluss (Iₒₚ und Iₒₙ) zu empfangen, der dritte Eingang konfiguriert ist, um eine Referenzspannung zu empfangen und um ein Steuersignal (636) an dem Ausgang zu erzeugen, um die Stromerfassungsschaltung (600) derart zu erzeugen, dass die Gleichtaktspannung gleich der Referenzspannung ist.

8. Leistungsverstärkerschaltung nach Anspruch 6, wobei die Stromerfassung ferner eine Gegentaktschleifenschaltung (630) umfasst, umfassend einen ersten Eingang (632) und einen zweiten Eingang (634) und einen Ausgang (636), wobei der erste und der zweite Eingang konfiguriert sind, um eine Spannungsdifferenz zu empfangen und ein Steuersignal (636) zu erzeugen, um die Spannungsdifferenz zu verringern.

9. Leistungsverstärkerschaltung nach Anspruch 7, wobei die Stromerfassungsschaltung ferner umfasst: einen ersten Transistor (M₁), umfassend eine Source, ein Gate und einen Drain, einen zweiten Transistor (M₂), umfassend eine Source, ein Gate und einen Drain, und einen ersten, zweiten, dritten und vierten Umwandlungswiderstand, umfassend ein erstes Ende und ein zweites Ende, wobei das erste Ende des ersten, zweiten, dritten und vierten Umwandlungswiderstands jeweils mit dem ersten, zweiten, dritten und vierten Eingangsanschluss gekoppelt ist, und das zweite Ende des ersten Widerstands mit dem ersten Eingang der Gegentaktschleifenschaltung und mit der Source des ersten Transistors (M₁) gekoppelt ist, das zweite Ende des zweiten Widerstands mit dem zweiten Eingang der Gegentaktschleifenschaltung und mit der Source des zweiten Transistors (M₂) gekoppelt ist, das zweite Ende des dritten Widerstands mit dem ersten Eingang der Gleichtaktschleifenschaltung und mit dem Drain des ersten Transistors (M₁) gekoppelt ist, das zweite Ende des vierten Widerstands mit dem zweiten Eingang der Gleichtaktschleifenschaltung und dem Drain des zweiten Transistors (M₂) gekoppelt ist, und die durch die Gleichtaktschleifenschaltung und die Gegentaktschleifenschaltung erzeugten Steuersignale die Gates des ersten Transistors (M₁) und des zweiten Transistor (M₂) steuern.

10. Leistungsverstärkerschaltung nach einem der Ansprüche 6 bis 8, wobei die Gleichtaktschleifenschaltung (610) ein Paar Differenzverstärkerschaltungen umfasst.

11. Leistungsverstärkerschaltung nach einem der Ansprüche 6 bis 8, wobei die Gegentaktschleifenschaltung (630) eine Differenzverstärkerschaltung umfasst.

12. Verfahren zum Betreiben einer Spannungserfassungsschaltung (400; 510) zum Messen einer mit einem Leistungsverstärker verbundenen Last, wobei die Last konfiguriert ist, um eine erste Spannung (Vᵢₚ) an einem ersten Ende und eine zweite Spannung (Vᵢₙ) an einem zweiten Ende zu empfangen, wobei die erste und die zweite Spannung gegenphasig sind, das Verfahren umfassend die folgenden Schritte:
Empfangen, an einem Eingang einer ersten Spannungsteilerschaltung (220) der Spannungserfassungsschaltung, der ersten Spannung (Vᵢₚ);
Empfangen, an einem Eingang einer zweiten Spannungsteilerschaltung (222) der Spannungserfassungsschaltung, der zweiten Spannung (Vᵢₙ);
Empfangen, an einem ersten Eingang (234) einer Treiberschaltung (400, 510) der Spannungserfassungsschaltung, einer Referenzspannung,
Empfangen, an einem zweiten Eingang (236) der Treiberschaltung (400, 510), eines Gleichtaktsignals von der ersten und der zweiten Spannungsteilerschaltung; und
Ansteuern, durch die Treiberschaltung (400, 510), einer Ausgangsgleichtaktspannung der ersten und der zweiten Spannungsteilerschaltung mit der Referenzspannung
wobei die Treiberschaltung (400, 510) ferner einen ersten und einen zweiten Widerstand (R₄ₚ, R₄ₙ) umfasst, die in Reihe zwischen dem ersten und dem zweiten Ausgangsanschluss geschaltet sind, sodass ein erstes Ende (402) des ersten Widerstands (R₄ₚ) elektrisch mit dem ersten Ausgangsanschluss (206) verbunden ist, ein zweites Ende (404) des ersten Widerstands (R₄ₚ) elektrisch mit einem ersten Ende (408) des zweiten Widerstands (R₄ₙ) und mit dem Ausgang (420) der Treiberschaltung verbunden ist, und ein zweites Ende (406) des zweiten Widerstands (R₄ₙ) elektrisch mit dem zweiten Ausgangsanschluss (208) verbunden ist.

## Revendications

1. Circuit de captage de tension (400 ; 500) permettant de mesurer une charge connectée à un amplificateur de puissance dans lequel la charge est configurée pour recevoir une première tension (Vᵢₚ) au niveau d'une première extrémité et une deuxième tension (Vᵢₙ) au niveau d'une seconde extrémité, dans lequel les première et deuxième tensions sont en opposition de phase, dans lequel le circuit de captage de tension comprend :
une première borne d'entrée (202) connectée électriquement à la première tension (Vᵢₚ) ;
une deuxième borne d'entrée (204) connectée électriquement à la deuxième tension (Vᵢₙ) ;
une première borne de sortie (206) ;
une seconde borne de sortie (208) ;
un premier circuit diviseur de tension (220) comprenant une entrée connectée électriquement à la première borne d'entrée (202) et une sortie connectée électriquement à la première borne de sortie (206) ;
un second circuit diviseur de tension (222) comprenant une entrée connectée électriquement à la deuxième borne d'entrée (204) et une sortie connectée électriquement à la seconde borne de sortie (208) ; le circuit de captage de tension étant **caractérisé en ce qu'**il comprend en outre
un circuit de pilotage (400, 510) comprenant une première entrée (234) configurée pour recevoir une tension de référence, une deuxième entrée (236) configurée pour recevoir un signal de mode commun provenant des premier et second circuits diviseurs de tension, et une sortie configurée pour piloter une tension de mode commun de sortie des premier et second circuits diviseurs de tension avec la tension de référence,
dans lequel le circuit de pilotage (400, 510) comprend en outre des première et deuxième résistances (R₄ₚ, R₄ₙ) connectées en série entre les première et seconde bornes de sortie de telle sorte qu'une première extrémité (402) de la première résistance (R₄ₚ) est connectée électriquement à la première borne de sortie (206), une seconde extrémité (404) de la première résistance (R₄ₚ) est connectée électriquement à une première extrémité (408) de la deuxième résistance (R₄ₙ) et à la sortie (420) du circuit de pilotage, et une seconde extrémité (406) de la deuxième résistance (R₄ₙ) est connectée électriquement à la seconde borne de sortie (208).

2. Circuit de captage de tension (400 ; 500) selon la revendication 1,
dans lequel le premier diviseur de tension (220) comprend une troisième résistance (R₁ₚ) et une quatrième résistance (R_{2P}) et le second diviseur de tension (222) comprend une cinquième résistance (R₁ₙ) et une quatrième résistance (R₂ₙ), et
dans lequel une première extrémité (302) de la troisième résistance (R₁ₚ) est connectée électriquement à la première borne d'entrée (202), une seconde extrémité (304) de la troisième résistance (R₁ₚ) est connectée électriquement à la première borne de sortie (206) et à une première extrémité (306) de la quatrième résistance (R_{2P}), une seconde extrémité (308) de la quatrième résistance (R_{2P}) est connectée électriquement à une première extrémité (318) de la quatrième résistance (R₂ₙ), une seconde extrémité (316) de la quatrième résistance (R₂ₙ) est connectée électriquement à la seconde borne de sortie (208) et à une première extrémité (314) de la cinquième résistance (R₁ₙ), et une seconde extrémité (312) de la troisième résistance (R₁ₙ) est connectée électriquement à la seconde borne de sortie (204).

3. Circuit de captage de tension (400 ; 500) selon la revendication 2, dans lequel la deuxième entrée (236) du circuit de pilotage (400, 510) est connectée électriquement à la seconde extrémité (308) de la quatrième résistance (R_{2P}) et à la première extrémité (318) de la quatrième résistance (R₂ₙ).

4. Circuit de captage de tension (500) selon la revendication 1, dans lequel le circuit de pilotage (510) comprend des première et seconde résistances de sortie (R₃ₚ-R₃ₙ) dans lequel la première résistance de sortie (R₃ₚ) est connectée entre la première borne de sortie (204) et la première extrémité (402) de la première résistance (R_{4P}) et la seconde résistance de sortie (R₃ₙ) est connectée entre la seconde borne de sortie (Iₒₙ) et la seconde extrémité de la deuxième résistance (R₂ₙ).

5. Circuit de captage de tension selon l'une quelconque des revendications précédentes, dans lequel le circuit de pilotage (400, 510) comprend un amplificateur opérationnel (422), et dans lequel une entrée non inverseuse de l'amplificateur d'opération (422) est connectée électriquement à la première entrée (234), dans lequel une entrée d'inversion de l'amplificateur opérationnel (422) est connectée électriquement à la deuxième entrée (236), et dans lequel une sortie (240) de l'amplificateur opérationnel (422) est connectée électriquement à la seconde extrémité (404) de la première résistance (R_{4P}) et à la première extrémité (408) de la deuxième résistance (R₄ₙ).

6. Circuit amplificateur de puissance (900) comprenant le circuit de captage de tension selon l'une quelconque des revendications précédentes.

7. Circuit amplificateur de puissance selon la revendication 5 comprenant en outre un circuit de captage de courant (600) permettant de mesurer une charge connectée à un amplificateur de puissance dans lequel la charge est configurée pour recevoir une première tension (V_{iP}) au niveau d'une première extrémité et une deuxième tension (Vᵢₙ) au niveau d'une seconde extrémité, dans lequel les première et deuxième tensions sont en opposition de phase, dans lequel le circuit de captage de courant comprend :
une première borne d'entrée (602) couplée à la première tension (V_{HSN}) ;
une deuxième borne d'entrée (604) couplée à la deuxième tension (V_{HSP}) ;
une troisième borne d'entrée (606) couplée à la troisième tension (V_{LSN}) ;
une quatrième borne d'entrée (608) couplée à la quatrième tension (V_{LSP}) ;
une première borne de sortie (Iₒₚ) ;
une seconde borne de sortie (Iₒₙ) ; et
un circuit de boucle de mode commun (610) comprenant une première entrée (612), une deuxième entrée (614), une troisième entrée (616) et une sortie (618) dans lequel les première et deuxième entrées sont configurées pour recevoir une tension de mode commun au niveau des première et seconde bornes de sortie (Iₒₚ et Iₒₙ), la troisième entrée est configurée pour recevoir une tension de référence, et pour générer un signal de commande (636) au niveau de la sortie pour commuter le circuit de captage de courant (600) de telle sorte que la tension de mode commun est égale à la tension de référence.

8. Circuit amplificateur de puissance selon la revendication 6, dans lequel le captage de courant comprend en outre un circuit de boucle de mode différentiel (630) comprenant une première entrée (632) et une deuxième entrée (634) et une sortie (636) dans lequel les première et deuxième entrées sont configurées pour recevoir une différence de tension et générer un signal de commande (636) pour réduire la différence de tension.

9. Circuit amplificateur de puissance selon la revendication 7, dans lequel le circuit de captage de courant comprend en outre un premier transistor (M₁) comprenant une source, une grille et un drain, un second transistor (M₂) comprenant une source, une grille et un drain, et des première, deuxième, troisième et quatrième résistances de conversion comprenant une première extrémité et une seconde extrémité dans lequel les premières extrémités des première, deuxième, troisième et quatrième résistances de conversion sont respectivement couplées aux première, deuxième, troisième et quatrième bornes d'entrée, et la seconde extrémité de la première résistance est couplée à la première entrée du circuit de boucle de mode différentiel et à la source du premier transistor (M₁), la seconde extrémité de la deuxième résistance est couplée à la deuxième entrée du circuit de boucle de mode différentiel et à la source du second transistor (M₂), la seconde extrémité de la troisième résistance est couplée à la première entrée du circuit de boucle de mode commun et au drain du premier transistor (M₁), la seconde extrémité de la quatrième résistance est couplée à la deuxième entrée du circuit de boucle de mode commun et au drain du second transistor (M₂), et les signaux de commande générés par le circuit de boucle de mode commun et le circuit de boucle de mode différentiel commandent les grilles du premier transistor (M₁) et du second transistor (M₂).

10. Circuit amplificateur de puissance selon l'une quelconque des revendications 6 à 8, dans lequel le circuit de boucle de mode commun (610) comprend une paire de circuits amplificateurs différentiels.

11. Circuit amplificateur de puissance selon l'une quelconque des revendications 6 à 8, dans lequel le circuit de boucle de mode différentiel (630) comprend un circuit amplificateur différentiel.

12. Procédé de fonctionnement d'un circuit de captage de tension (400 ; 510) permettant de mesurer une charge connectée à un amplificateur de puissance dans lequel la charge est configurée pour recevoir une première tension (Vᵢₚ) au niveau d'une première extrémité et une deuxième tension (Vᵢₙ) au niveau d'une seconde extrémité, dans lequel les première et deuxième tensions sont en opposition de phase, le procédé comprenant les étapes consistant à :
recevoir, au niveau d'une entrée d'un premier circuit diviseur de tension (220) du circuit de captage de tension, la première tension (Vᵢₚ) ;
recevoir, au niveau d'une entrée d'un second diviseur de tension circuit (222) du circuit de captage de tension, la deuxième tension (Vᵢₙ) ;
recevoir, au niveau d'une première entrée (234) d'un circuit de pilotage (400, 510) du circuit de captage de tension, une tension de référence,
recevoir, au niveau d'une deuxième entrée (236) du circuit de pilotage (400, 510), un signal de mode commun provenant des premier et second circuits diviseurs de tension ; et
piloter, par le circuit de pilotage (400, 510), une tension de mode commun de sortie des premier et second circuits diviseurs de tension avec la tension de référence,
dans lequel le circuit de pilotage (400, 510) comprend en outre des première et deuxième résistances (R₄ₚ, R₄ₙ) connectées en série entre les première et seconde bornes de sortie de telle sorte qu'une première extrémité (402) de la première résistance (R₄ₚ) est connectée électriquement à la première borne de sortie (206), une seconde extrémité (404) de la première résistance (R₄ₚ) est connectée électriquement à une première extrémité (408) de la deuxième résistance (R₄ₙ) et à la sortie (420) du circuit de pilotage, et une seconde extrémité (406) de la deuxième résistance (R₄ₙ) est connectée électriquement à la seconde borne de sortie (208).
